Europäisches Patentamt

(19) European Patent Office

Office européen des brevets

(11) Publication number: 0 077 737
A2

# (12) EUROPEAN PATENT APPLICATION

(21) Application number: 82401916.0

(22) Date of filing: 19.10.82

(51) Int. Cl.³: H 01 L 29/78
H 01 L 21/20, H 01 L 29/04
H 01 L 29/08, H 01 L 21/316

(30) Priority: 19.10.81 US 313003

(43) Date of publication of application:
27.04.83 Bulletin 83/17

(84) Designated Contracting States:
DE FR GB IT NL

(71) Applicant: FAIRCHILD CAMERA & INSTRUMENT
CORPORATION
464 Ellis Street
Mountain View California 94042(US)

(72) Inventor: Vora, Madhukar B.
110 Lansberry Court
Los Gatos California(US)

(74) Representative: Chareyron, Lucien et al,
Schlumberger Limited 42, rue Saint-Dominique
F-75340 Paris Cedex 07(FR)

(54) Low capacitance field effect transistor.

(57) A compact field effect transistor having extremely low source/drain to substrate capacitance is disclosed, together with a method of fabricating it. The source 27 and drain 25 regions of the FET are fabricated on an underlying layer of insulating material 12, typically silicon dioxide, while the gate region including a channel 24, is fabricated directly on the semiconductor substrate 10. The source/drain 27/25 and gate 24 regions are all simultaneously formed by deposition of a single layer of epitaxial silicon 21. In this manner a monocrystalline silicon gate region 24 is created with polycrystalline silicon source/drain regions 27/25. The different rate of growth of silicon dioxide over monocrystalline 24 and polycrystalline silicon 27/25 is utilized to create the gate oxide, while an overlying layer of doped polycrystalline silicon 30 serves as the gate electrode. The source/drain regions are typically doped by an impurity diffused from a layer of phosphorous glass deposited between the insulating material and the source/drain regions.

FIG. 5

EP 0 077 737 A2

1

50.4113

## LOW CAPACITANCE FIELD EFFECT TRANSISTOR

### BACKGROUND OF THE INVENTION

#### Field of the Invention

This invention relates to integrated circuits, and in particular, to a compact field effect transistor structure having very low capacitance and a method for fabricating it.

#### Description of the Prior Art

Many different types of field effect transistor (FET) structures and processes for fabricating them are now known. In conventional FET's of the prior art, spaced apart source and drain regions are formed in an underlying semiconductor substrate. A relatively thin layer of silicon dioxide, commonly termed gate oxide, is formed on the surface of the substrate between the source and drain regions. On top of the gate oxide a gate electrode, fabricated from an electrically conductive material, is deposited and defined. The gate electrode will typically be fabricated from metal or doped polycrystalline silicon. In enhancement mode field effect transistors a channel may be implanted or otherwise fabricated between the source and drain regions.

Unfortunately, such prior art FET's suffer from a number of disadvantages. Typically such structures have high capacitance between the source and substrate and between the drain and substrate, herein referred to as source/drain to substrate capacitance. In addition, such structures have low punch through voltage between the source and drain. Although the source/drain to substrate capacitance may be reduced by lowering the impurity concentration of the substrate, lowering the impurity concentration also tends to reduce the punch through voltage. Furthermore, both parameters deteriorate rapidly as the length of an enhancement mode FET channel is reduced below 1 micron because the depletion width of the source and drain regions are of about the same magnitude.

The processes by which prior art FET structures are formed also result in undesired consequences. For example, in conventional silicon gate FET fabrication processes a polycrystalline silicon gate electrode is deposited and defined. The gate electrode itself then functions as a mask for the introduction of impurities to define the source and drain regions. Because these regions tend to diffuse under the edge of the gate, undesired gate/source and gate/drain capacitances are created through the thin gate oxide. These capacitances have increasingly undesirable effects as increasingly larger memory arrays are fabricated.

Furthermore, prior art arrays of silicon gate FET's are difficult to fabricate with uniformly thin layers of insulation beneath the gate electrode. This is in part due to lifting of the edges of the polycrystalline silicon gate as surrounding regions of the silicon substrate are oxidized. The lifting of the gate causes the turn-on potential of individual transistors within an array to vary from one to another, thereby degrading performance of the array.

## SUMMARY OF THE INVENTION

A general object of this invention is to provide an improved field effect transistor and a method of making same.

In one embodiment a transistor structure fabricated according to the invention comprises a semiconductor substrate, first and second spaced apart regions of insulating material disposed on the substrate and separated from each other by an intervening region of the substrate, a layer of semiconductor material disposed across the first and the second regions and across the intervening region of the semiconductor substrate, a layer of insulating material disposed across the surface of the layer of semiconductor material, and an electrode overlying at least that portion of the layer of insulating material which overlies the intervening semiconductor substrate.

In one embodiment a method of fabricating an integrated circuit transistor structure according to the invention comprises forming a first layer of insulating material over first and second spaced apart regions of a semiconductor substrate, the first and second regions being separated by an intervening region of the semiconductor substrate, depositing a layer of selected conductivity type semiconductor material over the layer of insulating material and the intervening region, introducing opposite conductivity type impurity into the layer of semiconductor material overlying the layer of insulating material, forming a second layer of insulating material over the layer of semiconductor material, and fabricating an electrically conductive region over at least that portion of the second layer of insulating material overlying the intervening region.

BRIEF DESCRIPTION OF THE DRAWINGS

Figure 1 is a cross-sectional view of an integrated circuit structure which may be fabricated using known techniques and which is a starting point for the process of this invention.

Figure 1a illustrates an alternative cross-section which may also be utilized in fabricating the transistor structure of this invention.

Figure 2 is a subsequent cross-sectional view of the structure shown in Figure 1 after definition of the gate region.

Figure 3 is a subsequent cross-sectional view of the structure shown in Figure 2 after depositing epitaxial silicon and doping that silicon.

Figure 4 is a subsequent cross-sectional view illustrating the appearance of the structure after formation of the gate oxide.

Figure 5 is a subsequent cross-sectional view after formation of the gate electrode.

Figure 6 is a top view of the structure shown in Figure 5.

Figure 7 is a cross-sectional view of the structure shown in Figure 6 taken perpendicular to the cross-section shown in Figure 6.

## DESCRIPTION OF THE PREFERRED EMBODIMENTS

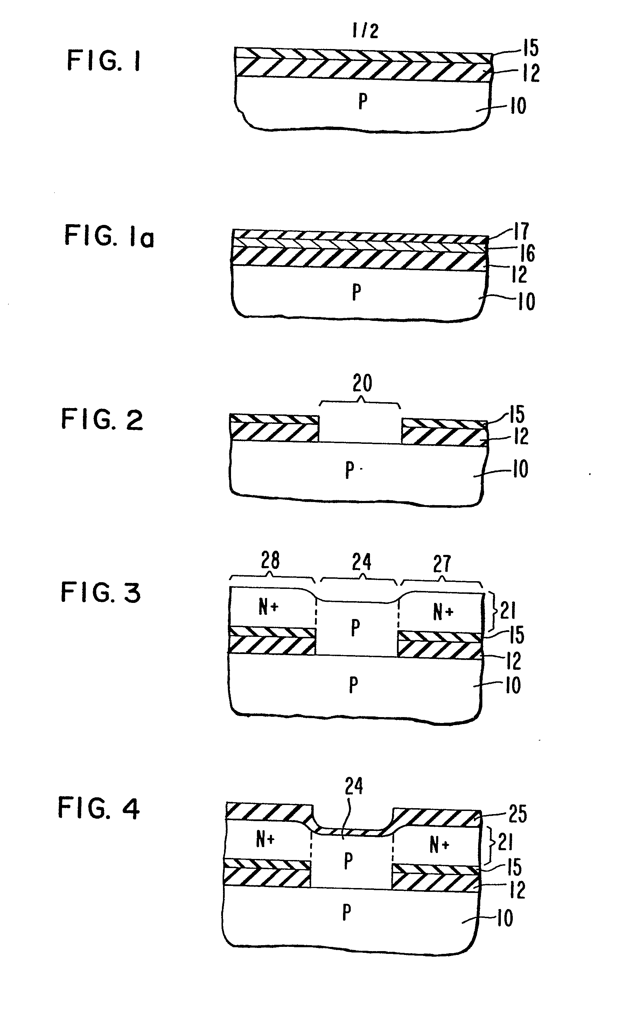

The integrated circuit structure depicted in Figure 1 may be fabricated using known techniques. As shown in Figure 1 on a suitable P conductivity semiconductor substrate 10, for example, doped with $5 \times 10^{16}$ atoms per cubic centimeter of boron, a layer of silicon dioxide 12 is formed. In the preferred embodiment silicon dioxide layer 12 is approximately 3,000 Angstroms thick and is fabricated by using any well known technique, for example, thermal oxidation. One such technique is to heat substrate 10 in an oxygen atmosphere to a temperature of 1000°C for 90 minutes. After fabrication of silicon dioxide 12, a relatively thin layer of phosphorous pentoxide ($P_2O_5$) glass 15 is formed on the upper surface of silicon dioxide 12. In the preferred embodiment the phosphorous glass 15 is 100 Angstroms thick and is fabricated by chemical vapor deposition. In such a process phosphine and oxygen are passed over the wafer to create the layer of phosphorous pentoxide on its surface. During subsequent heating, for example, for 30 minutes at 1000°C, the underlying silicon dioxide 12 will dissolve slightly allowing the upper approximately 1000 Angstroms of layer 12 to become doped with phosphorous ions. The resulting structure may then be further processed as described in conjunction with Figures 2 through 7.

An alternative structure which may be utilized as a starting point for the process described in conjunction with Figures 2 through 7 is the structure shown in Figure 1a. As shown in Figure 1a, substrate 10 and silicon dioxide layer 12 are fabricated in the same manner as discussed in conjunction with Figure 1. On the upper surface of silicon dioxide 12, however, is formed a layer of tantalum 16 approximately 500 Angstroms thick. Tantalum layer 16 may be fabricated by sputtering in a vacuum or by other known processes. On the upper surface of tantalum 16 a relatively thin layer of polycrystalline silicon 17, on the order of 1000 Angstroms thick, is deposited, for example, by chemical vapor deposition. The polycrystalline silicon 17 is then heavily doped with N conductivity type impurities. For example, in the preferred embodiment the doping concentration of layer 17 is $10^{20}$ phosphorous atoms per cubic centimeter. This may be achieved by well known diffusion or ion implantation techniques. Another technique for forming the tantalum/polycrystalline silicon layers is to use chemical vapor deposition to deposit tantalum 16, deposit polycrystalline silicon 17, and dope silicon layer 17 all in one operation.

The structure from either Figure 1 or Figure 1a is then subjected to further integrated circuit processing operations as described in Figure 2 and subsequent. Figures 2-7 illustrate the subsequent process operations in which the structure of Figure 1 is used. As shown in Figure 2, an opening 20 is made through phosphorous glass 15 and silicon dioxide 12. Opening 20 may be created using known photolithographic integrated circuit fabrication techniques, for example, forming a first mask and etching by chemicals or plasma. According to one such technique, layers 12 and 15 are removed by plasma etching with carbon tetrafluoride. If the structure shown in Figure 1a is utilized, then a first mask is formed and the opening through layer 17 is made with carbon tetrachloride plasma. Layers 16 and 12 are then etched using carbon tetrafluoride plasma.

As next shown in Figure 3, a layer of epitaxial silicon 21 is deposited across the upper surface of the structure shown in Figure 2. In the preferred embodiment the epitaxial silicon 21 is deposited approximately 5,000 Angstroms thick using a low pressure process to prevent the dopant in layer 15 from diffusing into what will become the channel 24 of the transistor structure. In region 24 where the epitaxial silicon 21 contacts the upper surface of substrate 10, monocrystalline silicon will be formed. In regions 27 and 28, however, where epitaxial silicon 21 overlies phosphorous glass 15, polycrystalline silicon will be formed. Region 24 of layer 21 is then doped to an appropriate level, for example, by ion implantation to a concentration of $5 \times 10^{16}$ atoms per cubic centimeter of boron.

The combined structure shown in Figure 3 is then heated to cause the phosphorous from the phosphorous glass 15 to diffuse out into epitaxial layer 21 in regions 27 and 28. In the preferred embodiment this is achieved by heating the structure to a 900°C for 40 minutes. The resulting N resistivity will be 10 ohms per square. Impurity concentrations between $5 \times 10^{19}$ and $10^{20}$ atoms per cubic centimeter have been found suitable for the fabrication of regions 27 and 28 in the structure depicted. Because region 24 of epitaxial layer 21 does not overlie phosphorous glass 15, no source of N conductivity type impurities is present for diffusion into region 24. Moreover, because the N conductivity type impurity diffuses in polycrystalline silicon 21 approximately four times faster than in monocrystalline silicon 24, the effective width of region 24 will be only slightly reduced by any lateral diffusion which occurs.

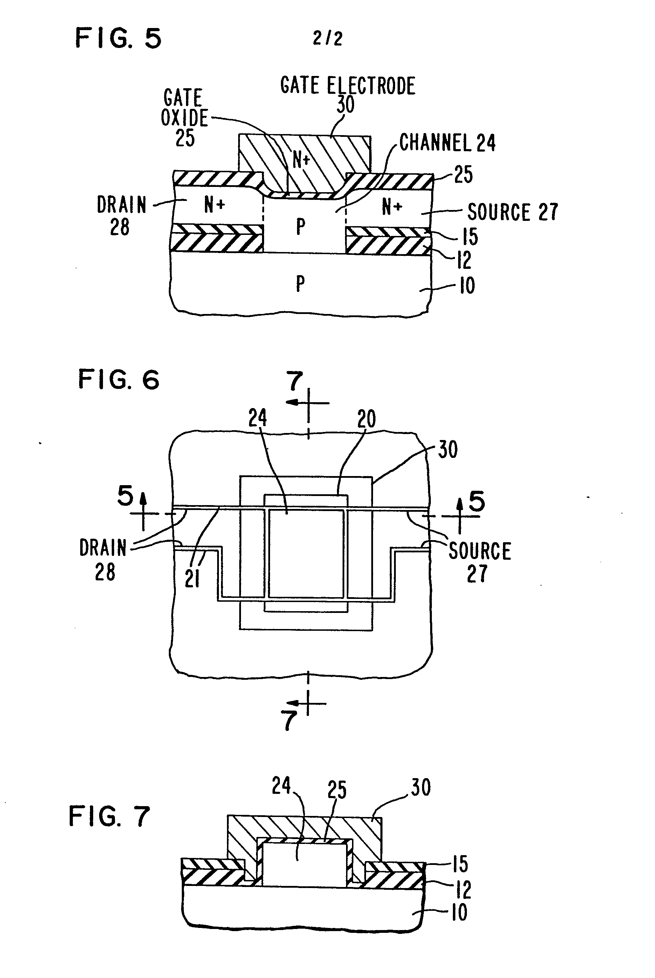

The outer lateral boundaries (shown in Figure 6) of N doped regions 27 and 28 may be then defined using a second mask and well-known photolithographic techniques.

Outside these boundaries epitaxial layer 21 will be removed using well known chemical etching, plasma etching, or other techniques.

As shown in Figure 4, a layer of silicon dioxide 25 is next formed on the upper surface of epitaxial layer 21. In the preferred embodiment layer 25 is fabricated by heating the underlying structure in an oxygen atmosphere to a temperature of about 800°C for 4 hours to form about 300 Angstroms of silicon dioxide on the upper surface of the P conductivity type portion of epitaxial layer 21 and about 1000 Angstroms of silicon dioxide on the upper surface of the N conductivity type portions of layer 21. The different rate of formation of silicon dioxide on underlying N and P conductivity type doped regions is a known phenomenon which is discussed in further detail in C. P. Ho et al. "Thermal Oxidation of Heavily Doped Silicon", J. Electrochem. Soc. 125, 665 (1978).

A layer of polycrystalline silicon 30 is then formed across the upper surface of silicon dioxide 25. Layer 30 may be deposited as N conductivity type doped polycrystalline silicon or may be deposited as relatively pure polycrystalline silicon which is subsequently doped with an appropriate impurity, for example, arsenic or phosphorous. In the preferred embodiment the impurity concentration of layer 30 is approximately $10^{20}$ atoms per cubic centimeter of phosphorous. Undesired portions of layer 30 may then be removed using well known photolithographic and etching techniques to define a gate electrode as shown in Figure 5.

As shown in Figures 5-7 the result of the process described is a field effect transistor of the enhancement mode type. The source/drain regions, gate oxide, and the oxide surrounding the gate oxide are all self-aligned. The process eliminates lifting of the gate electrode. Electrical connections to the source/drain regions may be made by suitable openings in silicon dioxide layer 25 at locations not shown in Figures 5-7.

In an alternative embodiment in which the structure of Figure 1a is utilized as a starting structure, the tantalum lines 17 beneath the source/drain regions will function as very low resistance electrical connections to the source/drain regions. This embodiment is particularly advantageous when the field effect transistor depicted is to be utilized in a semiconductor memory. In such an application the tantalum lines 17 will function as bit or word lines, while other subsequently formed lines will function as word or bit lines, respectively.

The transistor structure of Figures 5-7 is particularly advantageous as a field effect transistor because it may be fabricated using relatively few masking steps and has exceptionally low capacitance between the source/drain and the substrate. The low capacitance results from the layer of silicon dioxide 12 separating the source/drain regions from the substrate 10. In addition, the structure shown is completely self-aligned, that is, once the gate region 20 is defined, the source/drain regions and thicker oxide surrounding the gate are "automatically" fabricated on each side of the gate region without masking tolerances.

Figure 6 is a top view of the structure shown in Figure 5. For clarity, where boundaries of regions are fabricated aligned, the boundaries have been displaced slightly to display the extent of the depicted regions. For example, the coincident edges of the source/drain and channel have been displaced slightly to illustrate the boundaries of these regions. Gate electrode 30 completely overlies channel 24, which separates the source and drain. Because the channel will usually be wider than any contact to the source and drain, the source and drain may be reduced in width away from the channel as shown.

Figure 7 shows a cross-sectional view of the structure shown in Figures 5 and 6, illustrating the manner in which the gate electrode 30 overlies the channel 24. The gate oxide separates the gate 30 from channel 24, while oxide 12 and glass 15 separate gate 30 from the substrate 10 as shown.

Although two embodiments of the process and structure of this invention have been described above, it will be apparent to those skilled in the art that numerous variations and modifications may be made without departing from the scope of the invention as set forth in the appended claims. For example, the conductivity types of the various regions may be changed.

WHAT IS CLAIMED IS:

1. A method of fabricating an integrated circuit transistor structure characterized by:

forming a first layer of insulating material over first and second spaced apart regions of a semiconductor substrate, the first and the second regions being separated by an intervening region of the substrate;

depositing a layer of semiconductor material over the layer of insulating material and the intervening region;

introducing a first conductivity type impurity into that portion of the layer of semiconductor material overlying the intervening region and introducing an opposite conductivity type impurity into that portion of the layer of semiconductor material overlying the layer of insulating material;

forming a second layer of insulating material over the layer of semiconductor material; and

fabricating an electrically conductive region over at least that portion of the second layer of insulating material overlying the intervening region.

2. The method of claim 1 characterized by the step of fabricating a third layer of insulating material over the first and second spaced apart regions prior to the step of depositing a layer of selected conductivity type semiconductor material.

3. The method of claim 2 characterized in that the third layer of insulating material comprises a source of opposite conductivity type impurity.

4. The method of claim 2 or 3 characterized in that the third layer of insulating material comprises $P_2O_5$.

5. The method of any previous claim characterized in that the step of forming a first layer of insulating material comprises oxidizing the semiconductor substrate.

6. The method of any previous claim characterized in that the step of forming a second layer of insulating material comprises oxidizing the layer of semiconductor material.

7. The method of claim 6 characterized in that the layer of semiconductor material oxidizes more rapidly over the first and second spaced apart regions than over the intervening region of the substrate.

8. The method of any one of claims 2-7 characterized in that the step of fabricating an electrically conductive region comprises:
depositing a layer of polycrystalline silicon;
introducing impurities into the layer of polycrystalline silicon; and
removing undesired regions of the layer of polycrystalline silicon.

9. The method of any previous claim characterized in that a step of depositing an electrically conductive layer on the first layer of insulating material is performed following the step of forming a first layer of insulating material.

10. The method of claim 9 characterized in that a step of depositing a layer of polycrystalline silicon follows the step of depositing an electrically conductive layer.

11. A method of fabricating an integrated circuit transistor structure characterized by:
forming first and second spaced apart regions of oxidized semiconductor material overlaid by at least one selected layer on a semiconductor substrate;
depositing a layer of semiconductor material over the substrate and the at least one selected layer to thereby create regions of polycrystalline semiconductor material over the at least one selected layer and a region of monocrystalline semiconductor material over the substrate;

oxidizing the layer of semiconductor material; and forming an electrically conductive region of material over at least that portion of the oxidized layer of semiconductor material formed on the monocrystalline semiconductor material.

12. The method of claim 11 characterized in that the at least one selected layer comprises a first layer as a source of impurity dopant.

13. The method of claim 12 characterized in that the first layer provides impurity dopants for the overlying layer of semiconductor material.

14. The method of claim 13 characterized in that that at least one layer includes a second layer comprising electrically conductive material beneath the first layer.

15. An integrated circuit transistor structure characterized by:

a semiconductor substrate;

first and second spaced apart regions of insulating material disposed on the substrate, the first and second regions being separated by an intervening region of the substrate;

a layer of semiconductor material disposed across the first and the second regions and across the intervening region of the substrate;

a layer of insulating material disposed across the surface of the layer of semiconductor material; and

an electrode overlying at least that portion of the layer of insulating material which overlies the intervening region of the substrate.

16. The structure of claim 15 characterized in that the first and the second regions each comprise an oxide of the substrate.

17.  The structure of claim 15 or 16 characterized in that the layer of insulating material comprises an oxide of the substrate.

18.  The structure of claim 15, 16 or 17 characterized in that the substrate comprises silicon.

19.  The structure of any one of clams 15-18 characterized in that the electrode comprises electrically conductive polycrystalline silicon.

20.  The structure of any one of claims 15-19 characterized in that the layer of insulating material is thicker over the first and the second spaced apart regions than over the intervening region of the substrate.

21.  The structure of claim 20 characterized in that the electrode comprises N conductivity type doped polycrystalline silicon.

22.  The structure of any one of claims 15-21 characterized in that glass is formed over the first and the second spaced apart regions and beneath the layer of semiconductor material.

23.  The structure of claim 22 or 23 characterized in that the layer of glass comprises a source of impurity.

24.  The structure of claim 22 or 23 characterized in that the glass comprises $P_2O_5$.

25.  The structure of any one of claims 15-25 characterized in that a layer of electrically conductive material is deposited between the first spaced apart region and the layer of semiconductor material, and between the second spaced apart region and the layer of semiconductor material.

26. The structure of claim 25 characterized in that a layer of polycrystalline silicon is disposed over the layer of electrically conductive material.

27. The structure of claim 25 or 26 characterized in that the electrically conductive material comprises tantalum.

28. The structure of any one of claims 23-27 characterized in that the layer of glass comprises a source of impurity for doping selected regions of the layer of semiconductor material.

29. The structure of claim 28 characterized in that the selected regions of the layer of semiconductor material do not include that portion of the layer of semiconductor material disposed across the intervening region of the substrate.

30. The structure of any one of claims 22-29 characterized in that said layer of semiconductor material comprises silicon which is monocrystalline where disposed on the substrate and polycrystalline where disposed on the at least one layer.

0077737

FIG. 1

FIG. 1a

FIG. 2

FIG. 3

FIG. 4

FIG. 5

GATE ELECTRODE
30

GATE OXIDE 25

CHANNEL 24

N+

25

DRAIN 28

N+

P

N+

SOURCE 27

15

12

P

10

FIG. 6

24    20

30

5

DRAIN
28

SOURCE
27

21

7

FIG. 7

24    25    30

15

12

10